# EUROPEAN PATENT APPLICATION

(11) **EP 1 589 595 A2**
(43) Date of publication of application: **26.10.2005**
(21) Application number: 05008643.8
(22) Date of filing: 20.04.2005
(51) Int. Cl.: H01L 51/30, C09K 11/06, C08G 73/02, H05B 33/14

(54) **Charge transporting polymer and production process thereof, and polymer composition for organic electroluminescence device and organic electroluminescence device**

(30) Priority: 21.04.2004 JP 2004125577
(71) Applicant: JSR Corporation, Tokyo 104-0045 (JP)
(72) Inventor: Yasuda, Hiroyuki, Chuo-ku Tokyo 104-0045 (JP); Oh, Hyunshik, Chuo-ku Tokyo 104-0045 (JP); Shiraki, Shinji, Chuo-ku Tokyo 104-0045 (JP)
(74) Representative: TBK-Patent

(57) **Abstract**

The invention provide a novel charge transporting polymer capable of easily forming a thin film as being excellent in solubility in solvents and useful as electronic materials and other resin materials, a process for producing a novel charge transporting polymer excellent in solubility in solvents, capable of easily forming a thin film and useful as electronic materials and other resin materials, a polymer composition for organic electroluminescence device, by which an organic electroluminescence device excellent in luminescent properties and durability is provided, and an organic electroluminescence device.

The charge transporting polymer has a specific repeating unit. The production process of the charge transporting polymer is that reacting the specific compound and the specific N-(4-aminophenyl) carbazole compound.

## Description

### BACKGROUND OF THE INVENTION

### Field of the Invention:

The present invention relates to a novel charge transporting polymer useful as a material for organic electroluminescence device and a production process thereof, and a polymer composition for organic electroluminescence device and an organic electroluminescence device.

### Description of the Background Art:

An organic electroluminescence device (hereinafter also referred to as "organic EL device") is expected as a display device of the coming generation because it has such excellent properties as can be driven by DC voltage, is wide in angle of visibility and high in visibility as it is a self-luminescent device, and is fast in the speed of response, and researches thereof are being actively conducted.

As such organic EL devices, there have heretofore been known those of a single-layer structure that a luminescent layer composed of an organic material is formed between an anode and a cathode, and those of multi-layer structures such as a structure having a hole transporting layer between an anode and a luminescent layer and a structure having an electron transporting layer between a cathode and a luminescent layer. In all these organic EL elements, light is emitted by recombining an electron injected from the cathode with a hole injected from the anode in the luminescent layer.

As processes for forming functional organic material layers such as the luminescent layer and the charge transporting layers for transporting a charge such as an electron or hole in such an organic EL device, there have been known a dry method that an organic material layer is formed by vacuum deposition and a wet method that a solution of an organic material dissolved therein is applied and dried to form a layer. Among these, the dry method is difficult to meet mass production because the process is complicated, and there is a limit to the formation of a large-area layer. On the contrary, the wet method can meet mass production because the process is relatively simple. A large-area functional organic material layer can be easily formed by, for example, an ink-jet method. Accordingly, the wet method has the merits as described as above and is thus useful compared with the dry method.

On the other hand, the luminescent layer of the organic EL device is required to achieve high luminous efficiency. In order to realize high luminous efficiency, it has been recently attempted to utilize energy of a molecule in a triplet state that is an excitation state, or the like for light emission of an organic EL device.

More specifically, it has been reported that an external quantum efficiency of 8% exceeding 5% that has heretofore been considered to be a critical value of the external quantum efficiency in an organic EL device is achieved according to the organic EL device having such construction (see, for example, "Applied Physics Letters", Vol. 75, p. 4, 1999).

Since this organic EL device is formed with a low-molecular weight material and formed by the dry method, for example, a vapor deposition method or the like, however, it involves a problem that its physical durability and thermal durability are low.

As the organic EL device utilizing energy of the molecule in the triplet state, or the like, there has been proposed that obtained by forming a luminescent layer by the wet method by using a composition composed of, for example, an iridium complex compound and polyvinylcarbazole (see, for example, Japanese Patent Application Laid-Open No. 2001-257076).

This organic EL device is however poor in electrochemical stability because a vinyl group is present in the structure of polyvinylcarbazole and thus involves a problem that long service life cannot be achieved.

### SUMMARY OF THE INVENTION

The present invention has been made on the basis of the foregoing circumstances and has as its object the provision of a novel charge transporting polymer capable of easily forming a thin film as being excellent in solubility in solvents and useful as electronic materials and other resin materials, and particularly a novel charge transporting polymer useful as a material for an organic EL device for utilizing triplet luminescence as a substitute for polyvinylcarbazole.

Another object of the present invention is to provide a process for producing a novel charge transporting polymer excellent in solubility in solvents, capable of easily forming a thin film and useful as electronic materials and other resin materials.

A further object of the present invention is to provide a polymer composition for organic electroluminescence device, by which an organic electroluminescence device excellent in luminescent properties and durability is provided, and an organic electroluminescence device.

According to the present invention, there is thus provided a charge transporting polymer comprising a repeating unit represented by the following general formula (1) : 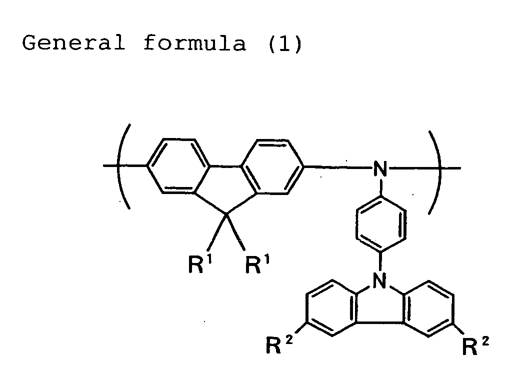 wherein R¹ is a monovalent organic group, and R² is a hydrogen atom or monovalent organic group, with the proviso that two R¹ groups may be bonded to each other to form a monocyclic structure or polycyclic structure.

The charge transporting polymer may preferably have a weight average molecular weight of 2,000 to 1,000,000 in terms of standard polystyrene equivalent as measured by gel permeation chromatography.

According to the present invention, there is also provided a process for producing a charge transporting polymer, which comprises the step of reacting a compound represented by the following general formula (2) with an N-(4-aminophenyl)carbazole compound represented by the following general formula (3), thereby obtaining the charge transporting polymer described above: 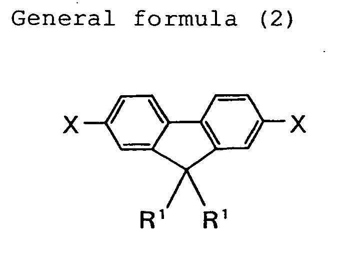 wherein X is a halogen atom, and R¹ is a monovalent organic group, with the proviso that two R¹ groups may be bonded to each other to form a monocyclic structure or polycyclic structure; 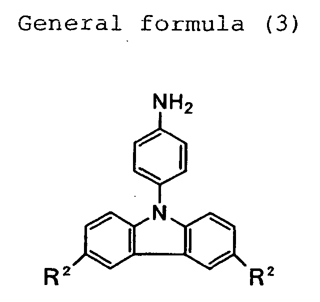 wherein R² is a hydrogen atom or monovalent organic group.

According to the present invention, there is further provided a charge transporting polymer comprising a repeating unit represented by the following general formula 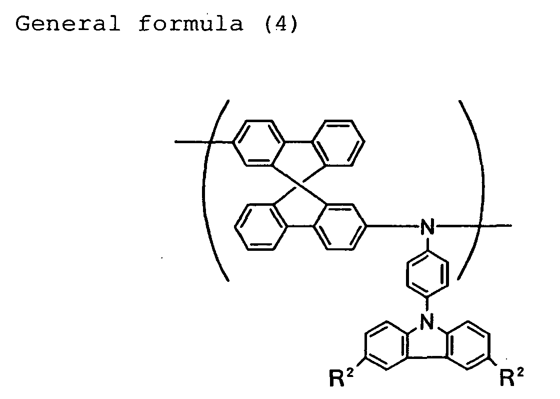 wherein R² is a hydrogen atom or monovalent organic group.

The charge transporting polymer may preferably have a weight average molecular weight of 2,000 to 1,000,000 in terms of standard polystyrene equivalent as measured by gel permeation chromatography.

According to the present invention, there is still further provided a process for producing a charge transporting polymer, which comprises the step of reacting a compound represented by the following general formula (5) with an N-(4-aminophenyl)carbazole compound represented by the following general formula (3), thereby obtaining the charge transporting polymer described above: 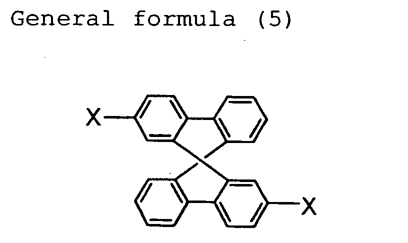 wherein X is a halogen atom; 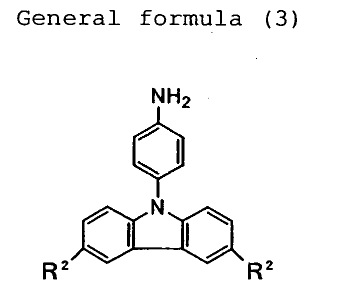 wherein R² is a hydrogen atom or monovalent organic group.

According to the present invention, there is yet still further provided a polymer composition for organic electroluminescence device, comprising a polymer component composed of any one of the above-described charge transporting polymers and a complex component composed of a triplet-luminescent metal complex compound.

According to the present invention, there is yet still further provided an organic electroluminescence device comprising a luminescent layer formed by the above-described polymer composition for organic electroluminescence device.

The organic electroluminescence device may preferably comprise a hole blocking layer.

Since the charge transporting polymers according to the present invention are excellent in solubility in solvents and capable of easily forming a thin film, and have good charge-transporting properties based on the properties of the polymers, they are useful as electronic materials and other resin materials. In addition, according to the charge transporting polymers, light emission by triplet luminescence can be achieved with high efficiency.

According to the processes of the present invention for producing the charge transporting polymer, the above-described charge transporting polymers can be produced.

According to the polymer composition for organic electroluminescence device of the present invention, organic electroluminescence device having excellent luminescent properties and durability can be provided because it comprises the charge transporting polymer according to the present invention as the polymer component.

According to the organic electroluminescence device of the present invention, excellent luminescent properties by triplet luminescence and durability can be achieved because it comprises a luminescent layer composed of the above polymer composition for organic electroluminescence device.

### BRIEF DESCRIPTION OF THE DRAWINGS

The above and other objects, features and advantages of the present invention will become apparent from the following description and the appended claims, taken in conjunction with the accompanying drawings, in which:
Fig. 1 is a cross-sectional view illustrating the construction of an exemplary organic electroluminescence device according to the present invention;
Fig. 2 illustrates a chart of an NMR spectrum of an organic EL device according to Example 1; and
Fig. 3 illustrates a chart of an NMR spectrum of an organic EL device according to Example 3.

### DETAILED DESCRIPTION OF THE PREFERRED EMBODIMENTS

The embodiments of the present invention will hereinafter be described in details.

### [Polymer according to the first embodiment]

The polymer according to the first embodiment of the present invention comprises the repeating unit represented by the general formula (1) and is obtained by reacting a compound (hereinafter also referred to as "bifunctional compound") having 2 substituents each composed of a halogen atom and represented by the general formula (2) with an N-(4-aminophenyl)carbazole compound (hereinafter also referred to as "specific carbazole compound") represented by the general formula (3).

In the general formula (1) , R¹ is a monovalent organic group. As specific examples of the monovalent organic group, may be mentioned alkyl, alkoxy and aryl groups. An alkyl group having, for example, 4 to 14 carbon atoms is particularly preferred.

The two R¹ groups may be bonded to each other to form a monocyclic structure or a polycyclic structure, for example, a spirofluorene structure or the like.

R² is a hydrogen atom or monovalent organic group. As specific examples of the monovalent organic group, may be mentioned alkyl, alkoxy, aryl and arylamino groups. A hydrogen atom or arylamino group is particularly preferred. In this formula, the fact that R² is a hydrogen atom indicates an unsubstituted state.

As specific examples of the arylamino group in R², may be mentioned diphenylamino, 4-biphenylphenylamino, 3-tolylphenylamino, 3,3'-dimethoxydiphenylamino, 4,4'-dimethoxydiphenylamino, 4-fluorodiphenylamino, 4,4'-difluorodiphenylamino and decafluorodiphenylamino groups.

The bifunctional compound represented by the general formula (2) is a fluorene derivative in which 2 substituents X are halogen atoms. As specific examples thereof, may be mentioned 2,7-dibromofluorene, 2,7-dichlorofluorene and 2,7-diiodofluorene.

### [Polymer according to the second embodiment]

The polymer according to the second embodiment of the present invention comprises the repeating unit represented by the general formula (4) and is obtained by reacting the above-described specific carbazole compound [N-(4-aminophenyl)carbazole compound represented by the general formula (3)] with a compound (hereinafter also referred to as "bifunctional compound") having 2 substituents each composed of a halogen atom and represented by the general formula (5).

The bifunctional compound represented by the general formula (5) is a spirofluorene derivative in which 2 substituents X are halogen atoms. As specific examples thereof, may be mentioned 2,2'-dibromospirofluorene, 2,2'-dichlorospirofluorene and 2,2'-diiodospirofluorene.

The average molecular weight of the polymer according to the first or second embodiment of the present invention is suitably selected according to the end application intended. However, its weight average molecular weight is preferably 2,000 to 1,000,000 in terms of standard polystyrene equivalent as measured by gel permeation chromatography in that good mechanical properties are achieved. It is particularly preferably 5,000 to 500,000 in that good solubility and processability are achieved.

The above-described polymers according to both first and second embodiments may be produced in accordance with a process which reacting the specific carbazole compound with the bifunctional compound in a proper polymerization solvent under the presence of a catalyst and a base.

In such a production process, as the catalyst, may preferably be used a palladium(II) compound such as palladium acetate, or a palladium(0) compound such as tris(dibenzylideneacetone)dipalladium or tetrakis-(triphenylphosphine)palladium.

No particular limitation is imposed on the amount of such a palladium compound used. However, it is preferably within a range of 0.00001 to 20.0 mol% in terms of palladium per mol of the halogen atom in the bifunctional compound in that the reaction can be caused to surely proceed. It is particularly preferably 0.001 to 10 mol% in terms of palladium per mol of the halogen atom in the bifunctional compound in view of profitability because the palladium compound is expensive.

Phosphine may preferably be used as a catalyst in combination with the above-described palladium compound.

No particular limitation is imposed on such phosphine. As examples thereof, may be mentioned trialkylphosphines such as triethylphosphine, tricyclohexylphosphine, triisopropylphosphine, tri-n-butylphosphine, triisobutylphosphine, tri-sec-butylphosphine and tri-tert-butylphosphine; and arylphosphines such as triphenylphosphine, tri(o-tolyl)phosphine, tri(m-tolyl)phosphine, tri(p-tolyl)-phosphine, 2,2'-bis(diphenylphosphino)-1,1'-binaphthyl (BINAP), trimesitylphosphine, diphenylphosphinoethane, diphenylphosphinopropane and diphenylphosphinoferrocene.

Among these, tri-tert-butylphosphine and diphenylphosphinoferrocene are preferred in that they have high reaction activity.

When the palladium compound and phosphine are used in combination as catalysts, they may be separately added to the reaction system. However, a complex of the palladium compound and phosphine may be prepared in advance to add the complex to the reaction system.

When the palladium compound and phosphine are used in combination as catalysts, the amount of the phosphine used is preferably within a range of 0.01 to 10,000 mol per mol of the palladium compound. It is particularly preferably within a range of 0.1 to 10 mol per mol of the palladium compound in view of profitability because the phosphine is expensive.

Examples of the base used for reacting the specific carbazole compound with the bifunctional compound may include carbonates such as sodium carbonate and potassium carbonate, inorganic bases such as alkali metal alkoxides, and organic bases such as tertiary amines. Specific preferable examples of the base include alkali metal alkoxides such as sodium methoxide, sodium ethoxide, potassium methoxide, potassium ethoxide, lithium tert-butoxide, sodium tert-butoxide and potassium tert-butoxide.

These bases may be added to the reaction system as it is. However, an alkali metal, alkali metal hydride or alkali metal hydroxide, and an alcohol may be added to the reaction system, and both compounds may be reacted with each other to prepare the intended base for the reaction.

No particular limitation is imposed on the amount of such a base used. However, it is preferably at least 0.5 mol per mol of the halogen atom in the bifunctional compound. Although the yield is not affected if the base is added in excess, the amount of the base used is preferably 1.0 to 5 mol per mol of the halogen atom in the bifunctional compound because a post-treatment operation after completion of the reaction becomes complicated if the base is added in excess.

No particular limitation is imposed on the polymerization solvent so far as it is an inert solvent that does not markedly inhibit the reaction of the specific carbazole compound with the bifunctional compound. As preferable examples thereof, may be mentioned aromatic hydrocarbon solvents such as benzene, toluene, xylene and mesitylene; ether solvents such as diethyl ether, tetrahydrofuran and dioxane; and acetonitrile, dimethylformamide, dimethyl sulfoxide and hexamethyl-phosphotriamide. Among these, aromatic hydrocarbon solvents such as benzene, toluene, xylene and mesitylene are particularly preferred.

In the production process according to the present invention, the reaction of the specific carbazole compound with the bifunctional compound is generally conducted under atmospheric pressure and an atmosphere of an inert gas such as nitrogen or argon. However, the reaction may be conducted under pressure.

With respect to specific reaction conditions, for example, the reaction temperature may be selected within a range of preferably 20°C to 250°C, more preferably 50°C to 150°C, and the reaction time may be selected within a range of preferably several minutes to 24 hours.

In this production process, a terminal of a polymer that is a reaction product obtained by the reaction of the specific carbazole compound with the bifunctional compound is preferably substituted by any aromatic compound, whereby a charge transporting polymer excellent in luminous efficiency and durability can be obtained.

According to the charge transporting polymers of the present invention, excellent solubility in solvents is achieved, and a coating formulation for forming a thin film can be easily prepared, so that a thin film can be easily formed by this coating formulation. Accordingly, the charge transporting polymers according to the present invention are useful as electronic material and other resin materials and particularly suitable as charge-transporting materials because they have charge-transporting property owing to the chemical structures thereof.

The charge transporting polymers according to the present invention may also be suitably used as materials for forming a luminescent layer of an organic EL device by, for example, combining them with a luminescent material having phosphorescent properties.

### <Polymer composition for organic EL device>

The polymer composition for organic EL devices according to the present invention comprises a polymer component composed of any one of the above-described charge transporting polymers and a complex component composed of a triplet-luminescent metal complex compound.

Examples of the triplet-luminescent metal complex compound making up the complex component include iridium complex compounds, platinum complex compounds, palladium complex compounds, rubidium complex compounds, osmium complex compounds and rhenium complex compounds. Among these, iridium complex compounds are preferred.

As the iridium complex compound making up the complex component, may be used a complex compound of iridium with a nitrogen atom-containing aromatic compound such as phenylpyridine, phenylpyrimidine, bipyridyl, 1-phenylpyrazole, 2-phenylquinoline, 2-phenylbenzothiazole, 2-phenyl-2-oxazoline, 2,4-diphenyl-1,3,4-oxadiazole, 5-phenyl-2-(4-pyridyl)-1,3,4-oxadiazole or a derivative thereof.

Specific examples of such an iridium complex compound include compounds represented by the following general formulae (6) to (8):

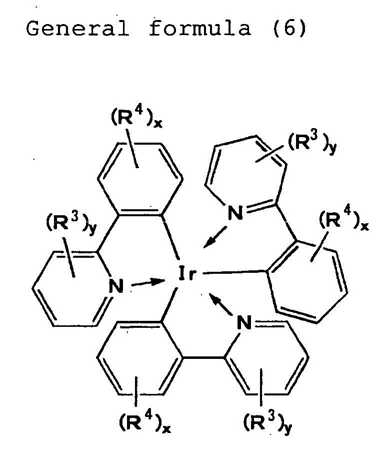

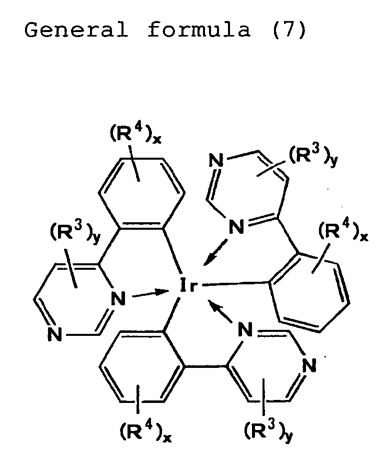

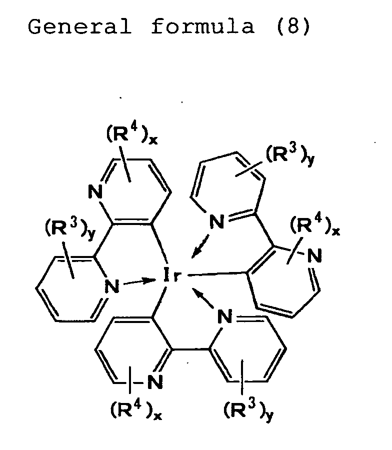

In the general formulae (6) to (8) , R³ and R⁴ are , independently of each other, a substituent composed of a fluorine atom, alkyl group or aryl group and may be the same or different from each other, x is an integer of 0 to 4, and y is an integer of 0 to 4.

In the above-described formulae, specific examples of the alkyl groups related to the substituents R³ and R⁴ include methyl, ethyl, isopropyl, t-butyl, n-butyl, isobutyl, hexyl and octyl groups.

Specific examples of the aryl groups include phenyl, tolyl, xylyl, biphenyl and naphthyl groups.

Among the above-described compounds, the iridium complex compound (hereinafter also referred to as "specific iridium complex compound") represented by the general formula (6) is preferably used.

The specific iridium complex compound can be generally synthesized by reacting a compound represented by the following general formula (9) with a compound represented by the following general formula (10) in the presence of a polar solvent. However, it is important that the content of a specific impurity compound represented by the following general formula (11), which is formed in this synthesis, be at most 1,000 ppm.

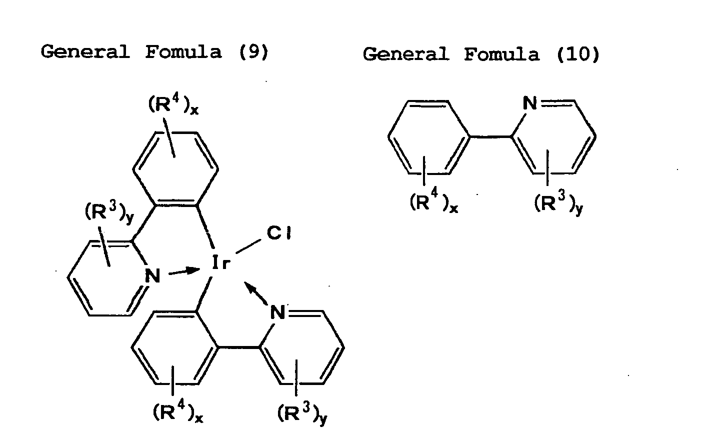

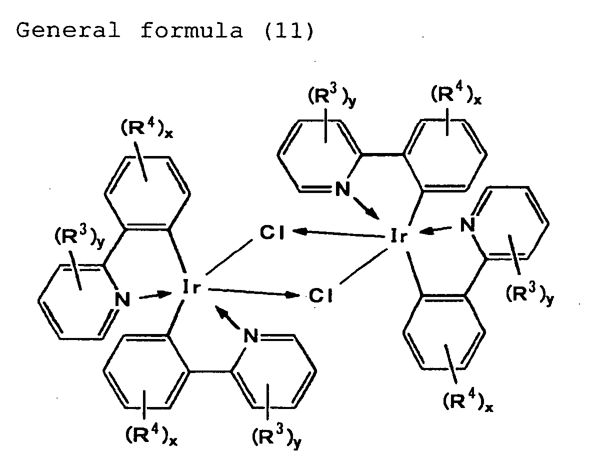

In the general formulae (9) to (11) , R³ and R⁴ have the same meanings as defined in the general formula (6), x is an integer of 0 to 4, and y is an integer of 0 to 4.

The specific iridium complex compound, in which the content of the specific impurity compound is at most 1,000 ppm, can be obtained by purifying the reaction product by the above-described synthetic reaction.

If the content of the specific impurity compound in the specific iridium complex compound exceeds 1,000 ppm, the luminescent performance that the specific iridium complex compound has is impaired, and so it is difficult to provide an organic EL device having high luminous luminance.

A proportion of the complex component in the polymer composition for organic EL devices according to the present invention is preferably 0.1 to 30 parts by mass, more preferably 0.5 to 10 parts by mass per 100 parts by mass of the polymer component. If the proportion of the complex component is too low, it may be difficult in some cases to achieve sufficient light emission. If the proportion of the complex component is too high on the other hand, a concentration quenching phenomenon that the brightness of light emission is rather reduced may occur in some cases. It is hence not preferable to use the complex component in such a too low or high proportion.

Any additive such as an electron-transporting low-molecular compound may be added to the polymer composition for organic EL devices according to the present invention as needed.

Examples of the electron-transporting low-molecular compound include metal complexes such as tris(8-hydroxyquinolino)aluminum (Alq3), oxadiazole compounds such as 2-(4-biphenyl)-5-(4-tert-butylphenyl)-1,3,4-oxadiazole (PBD), and triazole compounds such as 1-phenyl-2-biphenyl-5-tert-butylphenyl-1,3,4-triazole (TAZ). Oxadiazole compounds such as 2-(4-biphenyl)-5-(4-tert-butylphenyl)-1,3,4-oxadiazole (PBD) are particularly preferably used.

A proportion of the electron-transporting low-molecular compound contained is preferably 10 to 40 parts by mass per 100 parts by mass in total of the polymer component and complex component.

The polymer composition for organic EL devices according to the present invention is generally prepared as a composition solution by dissolving the polymer component composed of the specified polymer and the complex component in a proper organic solvent. This composition solution is applied to a surface of a substrate, on which a luminescent layer should be formed, and the resultant coating film is subjected to a treatment for removing the organic solvent, whereby the luminescent layer in the organic EL device can be formed.

No particular limitation is imposed on the organic solvent for preparing the composition solution so far as it can dissolve the polymer component and complex component used. Specific examples thereof include halogenated hydrocarbons such as chloroform, chlorobenzene and tetrachloroethane, amide solvents such as dimethylformamide and N-methylpyrrolidone, cyclohexanone, ethyl lactate, propylene glycol methyl ether acetate, ethyl ethoxypropionate, and methyl amyl ketone. These organic solvents may be used either singly or in any combination thereof.

Among these, that having a proper evaporation rate, specifically, an organic solvent having a boiling point of about 70 to 200°C is preferably used in that a thin film having a uniform thickness can be obtained.

A proportion of the organic solvent used varies according to the kinds of the polymer component and complex component. However, it is generally a proportion that the total concentration of the polymer component and complex component in the resulting composition solution amounts to 0.5 to 10% by mass.

As a means for applying the composition solution, may be used, for example, a spin coating method, dipping method, roll coating method, ink-jet method or printing method.

No particular limitation is imposed on the thickness of the luminescent layer formed. However, it is generally selected within a range of 10 to 200 nm, preferably 30 to 100 nm.

According to such a polymer composition for organic EL devices, an organic electroluminescence device having a luminescent layer that emits light at sufficiently high luminous luminance can be provided. In addition, the luminescent layer can be easily formed by a wet method such as an ink-jet method.

### <Organic EL Device>

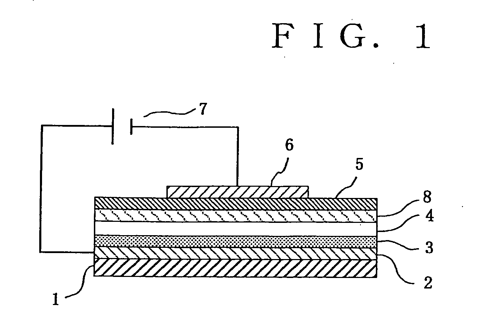

Fig. 1 is a cross-sectional view illustrating the construction of an exemplary organic EL device according to the present invention.

In the organic EL device of this embodiment, an anode 2 that is an electrode supplying a hole is provided by, for example, a transparent conductive film on a transparent substrate 1, and a hole injecting and transporting layer 3 is provided on this anode 2. A luminescent layer 4 is provided on the hole injecting and transporting layer 3, a hole blocking layer 8 is provided on the luminescent layer 4, and an electron injecting layer 5 is provided on the hole blocking layer 8. A cathode 6 that is an electrode supplying an electron is provided on this electron injection layer 5. The anode 2 and cathode 6 are electrically connected to a DC power source 7.

In this organic EL device, a glass substrate, transparent resin substrate, quartz glass substrate or the like may be used as the transparent substrate 1.

As a material for forming the anode 2, is preferably used a transparent material having a work function as high as, for example, at least 4 eV. In the present invention, the work function means the magnitude of minimum work required to take out an electron from a solid into a vacuum. As the anode 2, may be used, for example, an ITO (indium tin oxide) film, tin oxide (SnO₂) film, copper oxide (CuO) film or zinc oxide (ZnO) film.

The hole injecting and transporting layer 3 is provided for efficiently supplying a hole to the luminescent layer 4 and has a function of receiving the hole from the anode 2 and transporting it to the luminescent layer 4. As a material for forming the hole injecting and transporting layer 3, may be preferably used, for example, a charge injecting and transporting material such as poly(3,4-ethylenedioxy-thiophene)-polystyrenesulfonate. The thickness of the hole injecting and transporting layer 3 is, for example, 10 to 200 nm.

The luminescent layer 4 is a layer having a function of bonding an electron to a hole to emit the bond energy thereof as light. This luminescent layer 4 is formed by the above-described polymer composition for organic EL devices. No particular limitation is imposed on the thickness of the luminescent layer 4. However, it is generally selected within a range of 5 to 200 nm.

The hole blocking layer 8 is a layer having a function of inhibiting the hole supplied to the luminescent layer 4 through the hole injecting and transporting layer 3 from penetrating into the electron injecting layer 5 to facilitate recombination of the hole with the electron in the luminescent layer 4, thereby improving luminous efficiency.

As a material for forming the hole blocking layer 8, may preferably be used, for example, 2,9-dimethyl-4,7-diphenyl-1,10-phenanthroline (bathocuproine: BCP) represented by the following formula (1) or 1,3,5-tri(phenyl-2-benzimidazolyl)benzene (TPBI) represented by the following formula (2).

The thickness of the hole blocking layer 8 is, for example, 10 to 30 nm.

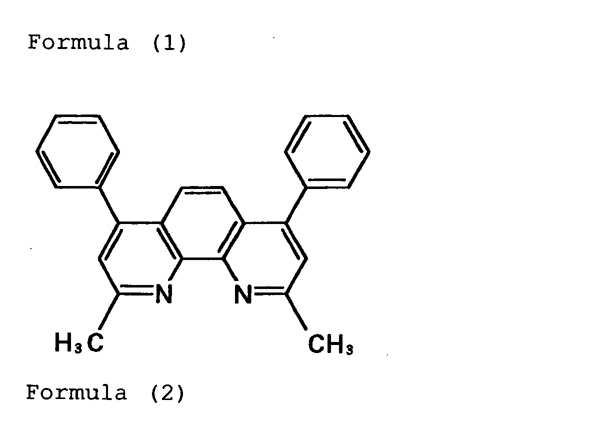

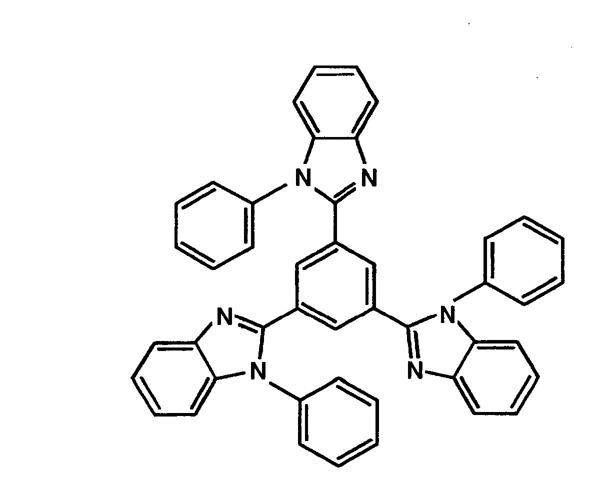

The electron injecting layer 5 is a layer having a function of transporting an electron received from the cathode 6 to the luminescent layer 4 through the hole blocking layer 8. As a material for forming the electron injecting layer 5, is preferably used a co-deposition system (BPCs) of a bathophenanthroline based material and cesium. As other materials, may be used alkali metals and their compounds (for example, lithium fluoride and lithium oxide), alkaline earth metals and their compounds (for example, magnesium fluoride and strontium fluoride), and the like. The thickness of the electron injecting layer 5 is, for example, 0.1 to 100 nm.

As a material for forming the cathode 6, is used a material having a work function as low as, for example, at most 4 eV. Specific examples of the cathode 6 include films composed of a metal such as aluminum, calcium, magnesium or indium and films composed of an alloy of these metals.

The thickness of the cathode 6 varies according to the kind of the material used. However, it is generally 10 to 1,000 nm, preferably 50 to 200 nm.

In the present invention, the organic EL device is produced, for example, in the following manner.

The anode 2 is first formed on the transparent substrate 1.

As a method for forming the anode 2, may be used a vacuum deposition method, sputtering method or the like. Alternatively, a commercially available material that a transparent conductive film, for example, an ITO film, has been formed on the surface of a transparent substrate such as a glass substrate may also be used.

The hole injecting and transporting layer 3 is formed on the anode 2 formed in such a manner.

As a specific method for forming the hole injecting and transporting layer 3, may be used a method in which a charge injecting and transporting material is dissolved in a proper solvent, thereby preparing a solution for forming a hole injecting and transporting layer, this hole injecting and transporting layer-forming solution is applied to the surface of the anode 2, and the resultant coating film is subjected to a treatment for removing the organic solvent, thereby forming the hole injecting and transporting layer 3.

The polymer composition for organic EL devices according to the present invention is then used as a luminescent layer-forming solution and this luminescent layer-forming solution is applied on to the hole injecting and transporting layer 3. The resultant coating film is heat-treated, thereby forming the luminescent layer 4.

As a method for applying the luminescent layer-forming solution, may be used a spin coating method, dipping method, ink-jet method or printing method.

The hole blocking layer 8 is then formed on the luminescent layer 4 formed in such a manner, the electron injecting layer 5 is formed on this hole blocking layer 8, and the cathode 6 is further formed on the electron injecting layer 5, thereby obtaining the organic EL device (1) having the construction illustrated in Fig. 1.

In the above-described process, as a method for forming the hole blocking layer 8, electron injecting layer 5 and cathode 6, may be used a dry method such as a vacuum deposition method.

In the above-described organic EL device, when DC voltage is applied between the anode 2 and the cathode 6 by the DC power source 7, the luminescent layer 4 emits light. This light is emitted to the outside through the hole injecting and transporting layer 3, anode 2 and transparent substrate 1.

According to the organic EL device of such construction, high luminous luminance is achieved because the luminescent layer 4 is formed by the above-described polymer composition for organic EL devices.

In addition, the hole blocking layer 8 is provided, whereby combination of a hole injected from the anode 2 with an electron injected from the cathode 6 is realized at high efficiency. As a result, high luminous luminance and luminous efficiency are achieved.

The present invention will hereinafter be described specifically by the following Examples. However, the present invention is not limited to these examples.

### Example 1:

In this Example 1, is described an example that a polymer according to the first embodiment is prepared.

A solution obtained by dissolving 0.55 g (1 mmol) of 9,9-dioctyl-2,7-dibromofluorene that X in the general formula (2) is a bromine atom, and R¹ is an alkyl group having 8 carbon atoms, 0.62 g (1 mmol) of 3,6-bis(phenyl-m-tolylamino)-N-(4-aminophenyl)carbazole that R² in the general formula (3) is a phenyl-m-tolylamino group, 0.03 g (0.03 mmol) of tris(dibenzylideneacetone)dipalladium (Pd₂ (dba) ₃) , 0.05 g (0.09 mmol) of diphenylphosphinoferrocene (DPPF) and 0.29 g (3 mmol) of sodium tert-butoxide in 10 ml of mesitylene was heated to 140°C to conduct a reaction for 35 hours.

Thereafter, 0.08 g (0.5 mmol) of diphenylamine was added to the reaction mixture at the same temperature to conduct a reaction for 4 hours, and 0.16 g (1 mmol) of bromobenzene was then added to further conduct a reaction for 4 hours for substituting the terminal of the resultant polymer.

An aqueous solution of ethylenediamine was added to the resultant reaction mixture, separation extraction was conducted with chloroform, the resultant organic layer was dried over anhydrous magnesium sulfate, the organic solvent was removed by vacuum distillation, and a reprecipitation treatment was then conducted with acetone to obtain 0.34 g of Polymer A1.

Polymer A1 had a weight average molecular weight of 17,000 in terms of standard polystyrene equivalent as measured by gel permeation chromatography.

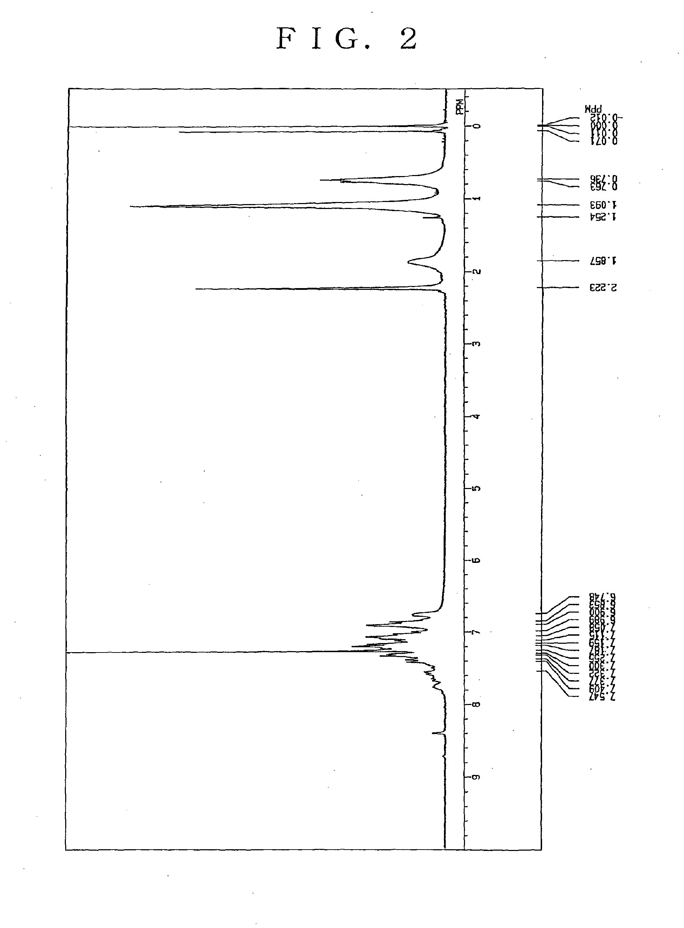

Polymer A1 was identified as a polymer represented by the following structural formula (1A) by NMR analysis. The result of the NMR measurement is illustrated in Fig. 2.

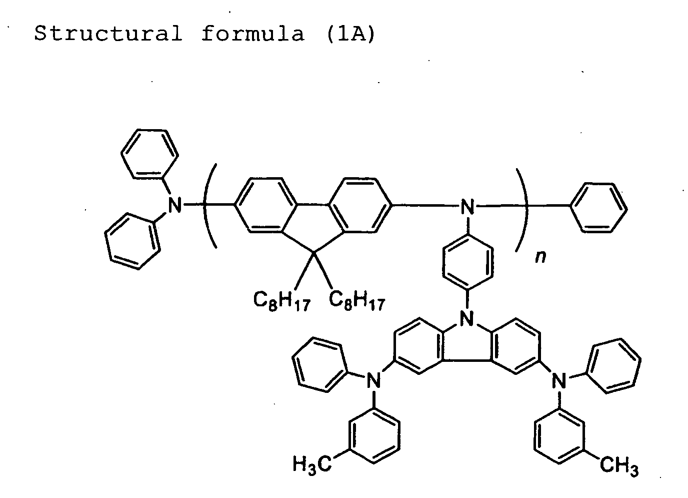

### Example 2:

In this Example 2, is described an example that a polymer according to the first embodiment is prepared.

A solution obtained by dissolving 0.55 g (1 mmol) of 9,9-dioctyl-2,7-dibromofluorene that X in the general formula (2) is a bromine atom, and R¹ is an alkyl group having 8 carbon atoms, 0.26 g (1 mmol) of N-(4-aminophenyl)carbazole that R² in the general formula (3) is a hydrogen atom, 0.03 g (0.03 mmol) of tris(dibenzylideneacetone) dipalladium (Pd₂ (dba) ₃) , 0.05 g (0.09 mmol) of diphenylphosphinoferrocene (DPPF) and 0.29 g (3 mmol) of sodium tert-butoxide in 10 ml of mesitylene was heated to 140°C to conduct a reaction for 35 hours.

Thereafter, 0.08 g (0.5 mmol) of diphenylamine was added to the reaction mixture at the same temperature to conduct a reaction for 4 hours, and 0.16 g (1 mmol) of bromobenzene was then added to further conduct a reaction for 4 hours for substituting the terminal of the resultant polymer.

An aqueous solution of ethylenediamine was added to the resultant reaction mixture, separation extraction was conducted with chloroform, the resultant organic layer was dried over anhydrous magnesium sulfate, the organic solvent was removed by vacuum distillation, and a reprecipitation treatment was then conducted with acetone to obtain 0.34 g of Polymer A2.

Polymer A2 had a weight average molecular weight of 17,000 in terms of standard polystyrene equivalent as measured by gel permeation chromatography.

Polymer A2 was identified as a polymer represented by the following structural formula (2A).

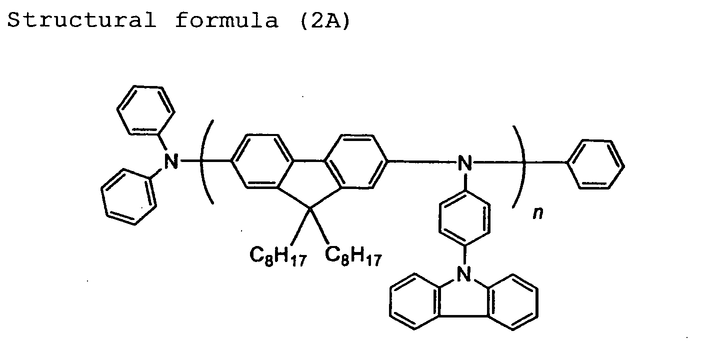

### Example 3:

In this Example 3, is described an example that a polymer according to the second embodiment is prepared.

A solution obtained by dissolving 0.62 g (1 mmol) of 3,6-bis(phenyl-m-tolylamino)-N-(4-aminophenyl)carbazole that R² in the general formula (3) is a phenyl-m-tolylamino group, 0.47 g (1 mmol) of 2,2'-dibromospirofluorene that X in the general formula (5) is a bromine atom, 0.03 g (0.03 mmol) of tris(dibenzylideneacetone)dipalladium (Pd₂(dba)₃), 0.05 g (0.09 mmol) of diphenylphosphinoferrocene (DPPF) and 0.29 g (3 mmol) of sodium tert-butoxide in 10 ml of mesitylene was heated to 140°C to conduct a reaction for 35 hours.

Thereafter, 0.08 g (0.5 mmol) of diphenylamine was added to the reaction mixture at the same temperature to conduct a reaction for 4 hours, and 0.16 g (1 mmol) of bromobenzene was then added to further conduct a reaction for 4 hours for substituting the terminal of the resultant polymer.

An aqueous solution of ethylenediamine was added to the resultant reaction mixture, separation extraction was conducted with chloroform, the resultant organic layer was dried over anhydrous magnesium sulfate, the organic solvent was removed by vacuum distillation, and a reprecipitation treatment was then conducted with acetone to obtain 0.54 g of Polymer B1.

Polymer B1 had a weight average molecular weight of 12,000 in terms of standard polystyrene equivalent as measured by gel permeation chromatography.

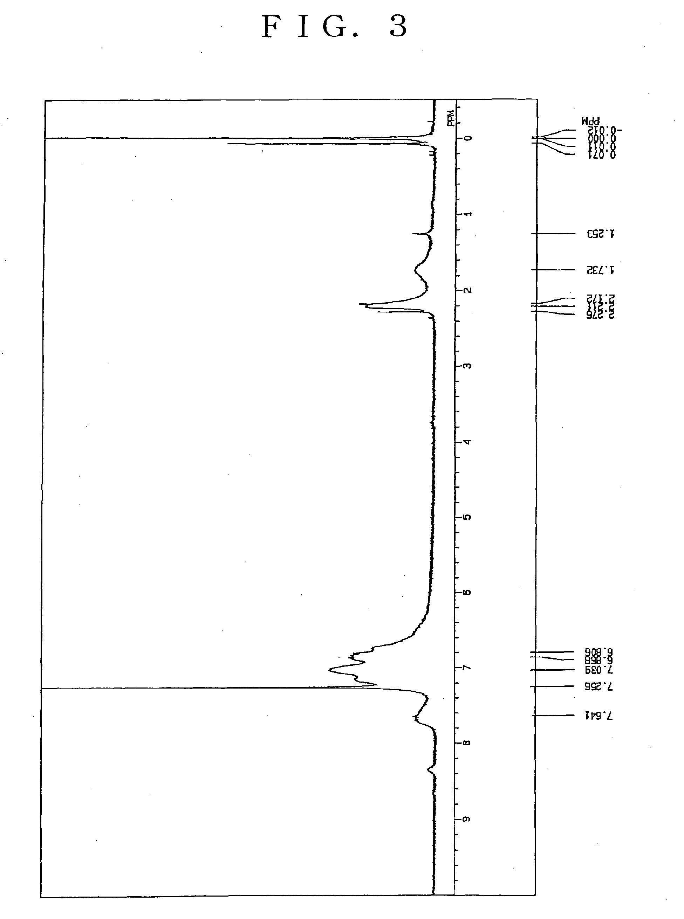

Polymer B1 was identified as a polymer represented by the following structural formula (1B) by NMR analysis. The result of the NMR measurement is illustrated in Fig. 3.

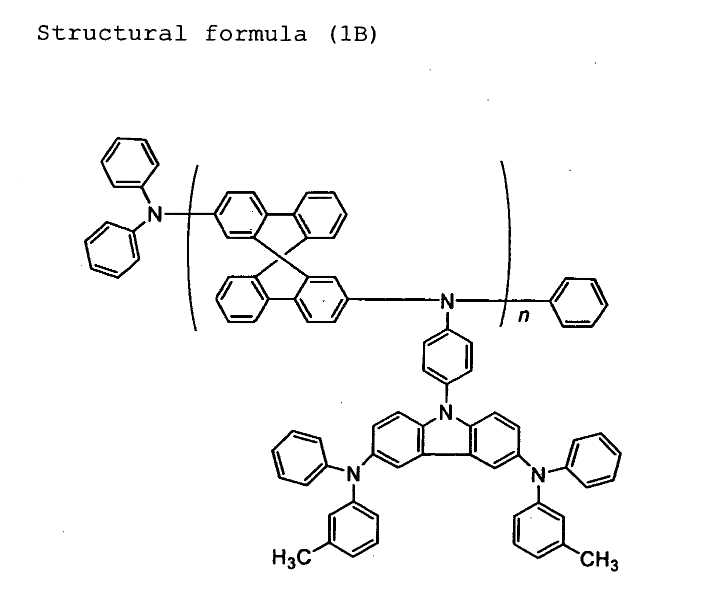

### Example 4:

### (Production of organic EL device)

An ITO substrate, in which an ITO film had been formed on a transparent substrate, was provided, and this ITO substrate was subjected to ultrasonic cleaning by using a neutral detergent, ultrapure water, isopropyl alcohol, ultrapure water and acetone in that order and then further subjected to ultraviolet-ozone (UV/O₃) cleaning.

A solution of poly(3,4-ethylenedioxythiophene)-polystyrenesulfonate (PEDOT/PSS) was applied on to the cleaned ITO substrate by a spin coating method, and the resultant coating film having a thickness of 65 nm was then dried at 250°C for 30 minutes under a nitrogen atmosphere, thereby forming a hole injecting and transporting layer.

A polymer composition solution for organic EL devices obtained by dissolving Polymer B1 and 6 mol% of the specific iridium complex that x and y in the general formula (6) are both 0 in hexanone so as to give a concentration of 3 % by mass was then applied as a solution for forming a luminescent layer to the surface of the hole injecting and transporting layer thus obtained by a spin coating method, and the resultant coating film having a thickness of 40 nm was dried at 120°C for 10 minutes under a nitrogen atmosphere, thereby forming a luminescent layer.

A laminate, in which the hole injecting and transporting layer and the luminescent layer had been laminated on the ITO substrate in that order, was fixed within a vacuum device, and the pressure within the vacuum device was then reduced to 1 x 10⁻⁴ Pa or lower to vapor-deposit bathocuproine in a thickness of 30 nm, thereby forming a hole blocking layer. After vapor deposition was then conducted with lithium fluoride to form an electron injecting layer having a thickness of 0.5 nm, calcium (30 nm) and aluminum (100 nm) were vapor-deposited in that order, thereby forming a cathode. Thereafter, sealing was conducted with a glass material, thereby producing an organic EL device.

In the organic EL device thus obtained, luminescent was observed at a wavelength of about 515 nm derived from the specific iridium complex.

The invention provide a novel charge transporting polymer capable of easily forming a thin film as being excellent in solubility in solvents and useful as electronic materials and other resin materials, a process for producing a novel charge transporting polymer excellent in solubility in solvents, capable of easily forming a thin film and useful as electronic materials and other resin materials, a polymer composition for organic electroluminescence device, by which an organic electroluminescence device excellent in luminescent properties and durability is provided, and an organic electroluminescence device.
The charge transporting polymer has a specific repeating unit. The production process of the charge transporting polymer is that reacting the specific compound and the specific N-(4-aminophenyl) carbazole compound.

## Claims

1. A charge transporting polymer comprising a repeating unit represented by the following general formula (1) : 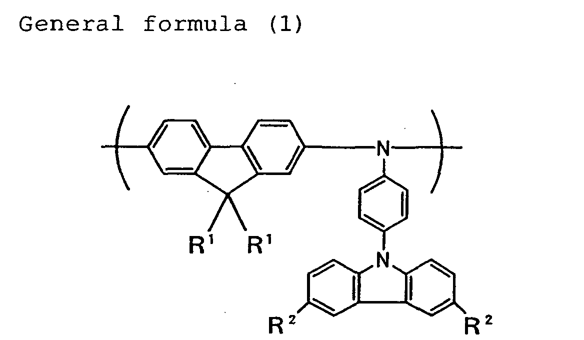 wherein R¹ is a monovalent organic group, and R² is a hydrogen atom or monovalent organic group, with the proviso that two R¹ groups may be bonded to each other to form a monocyclic structure or polycyclic structure.

2. The charge transporting polymer according to claim 1, which has a weight average molecular weight of 2,000 to 1,000,000 in terms of standard polystyrene equivalent as measured by gel permeation chromatography.

3. A process for producing a charge transporting polymer, which comprises the step of reacting a compound represented by the following general formula (2) with an N-(4-aminophenyl)carbazole compound represented by the following general formula (3), thereby obtaining the charge transporting polymer according to claim 1 or 2: 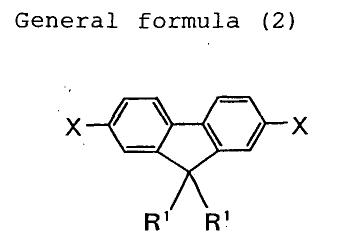 wherein X is a halogen atom, and R¹ is a monovalent organic group, with the proviso that two R¹ groups may be bonded to each other to form a monocyclic structure or polycyclic structure; 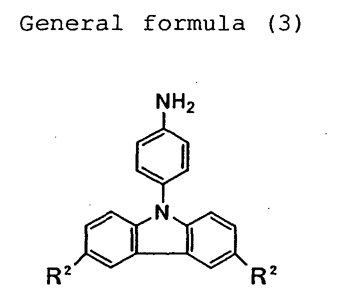 wherein R² is a hydrogen atom or monovalent organic group.

4. A polymer composition for organic electroluminescence device, comprising a polymer component composed of the charge transporting polymer according to claim 1 or 2 and a complex component composed of a triplet-luminescent metal complex compound.

5. An organic electroluminescence device comprising a luminescent layer formed by the polymer composition for organic electroluminescence device according to claim 4.

6. The organic electroluminescence device according to claim 5, which comprises a hole blocking layer.

7. A charge transporting polymer comprising a repeating unit represented by the following general formula (4) : 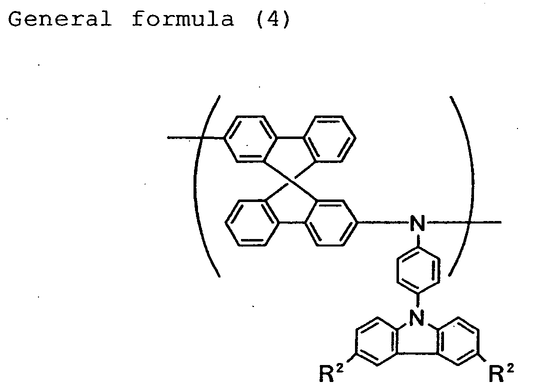 wherein R² is a hydrogen atom or monovalent organic group.

8. The charge transporting polymer according to claim 7, which has a weight average molecular weight of 2,000 to 1,000,000 in terms of standard polystyrene equivalent as measured by gel permeation chromatography.

9. A process for producing a charge transporting polymer, which comprises the step of reacting a compound represented by the following general formula (5) with an N-(4-aminophenyl)carbazole compound represented by the following general formula (3), thereby obtaining the charge transporting polymer according to claim 7 or 8: 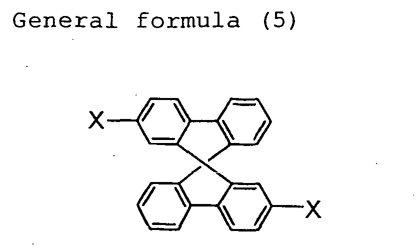 wherein X is a halogen atom; 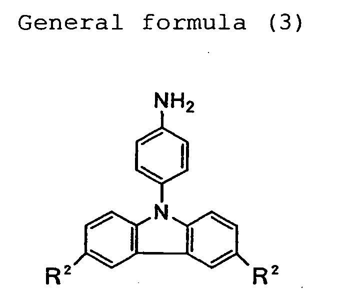 wherein R² is a hydrogen atom or monovalent organic group.

10. A polymer composition for organic electroluminescence device, comprising a polymer component composed of the charge transporting polymer according to claim 7 or 8 and a complex component composed of a triplet-luminescent metal complex compound.

11. An organic electroluminescence device comprising a luminescent layer formed by the polymer composition for organic electroluminescence device according to claim 10.

12. The organic electroluminescence device according to claim 11, which comprises a hole blocking layer.
